# EUROPEAN PATENT APPLICATION

(11) **EP 4 845 361 A1**
(43) Date of publication of application: **25.11.2026**
(21) Application number: 25757610.8
(22) Date of filing: 27.01.2025
(51) Int. Cl.: H10K 30/35, H10K 30/57

(54) **TANDEM SOLAR CELL, PHOTOVOLTAIC MODULE, POWER GENERATION DEVICE, AND ELECTRIC DEVICE**

(30) Priority: 23.02.2024 CN 202410206006
(71) Applicant: Contemporary Amperex Technology Co., Limited, Ningde, Fujian 352100 (CN)
(72) Inventor: ZHOU, Zichun, Ningde, Fujian 352100 (CN); ZHANG, Zhiying, Ningde, Fujian 352100 (CN); HONG, Wanru, Ningde, Fujian 352100 (CN); CHEN, Guodong, Ningde, Fujian 352100 (CN); OUYANG, Chuying, Ningde, Fujian 352100 (CN)
(74) Representative: Kraus & Lederer PartGmbB
(86) International application number: PCT/CN2025/075433
(87) International publication number: WO 2025/176013

(57) **Abstract**

A tandem solar cell, a photovoltaic module, and an electric device. The tandem solar cell comprises a first electrode and a second electrode; at least a first battery unit and second battery unit which are arranged between the first electrode and the second electrode and arranged in sequence in a first direction; and a composite layer arranged between the first battery unit and the second battery unit, the first direction being an incident direction of light. The first battery unit comprises a first light absorption layer, a first electron transport layer, a first hole blocking layer arranged on the side of the first electron transport layer close to the first light absorption layer, and a second hole blocking layer arranged on the side of the first electron transport layer distant from the first light absorption layer, wherein the first light absorption layer, the first electron transport layer, the first hole blocking layer, and the second hole blocking layer are stacked, and the first light absorption layer comprises a perovskite material.

## Description

### CROSS-REFERENCE TO RELATED APPLICATIONS

This disclosure claims priority to Chinese Patent Application No. 202410206006.8, filed on February 23, 2024 and entitled "TANDEM SOLAR CELL, PHOTOVOLTAIC MODULE, POWER GENERATION APPARATUS, AND ELECTRIC APPARATUS", which is incorporated herein by reference in its entirety.

### TECHNICAL FIELD

This disclosure relates to the technical field of batteries, and in particular, to a tandem solar cell, a photovoltaic module, a power generation apparatus, and an electric apparatus.

### BACKGROUND

Solar cells, also known as photovoltaic cells, are apparatuses that directly convert light energy into electrical energy through the photoelectric or photochemical effect. As an ideal renewable energy source, solar cells are receiving increasing attention.

With the development of solar cell technologies, higher requirements are posed on performance of the solar cells. Tandem solar cells, due to their high photoelectric conversion efficiency, have a great application prospect.

A tandem solar cell includes at least two battery cells arranged in a stacked configuration. In each battery cell, a light absorption layer is in direct contact with an electron transport layer. When electrons and holes dissociated from the light absorption layer reach the electron transport layer, non-radiative recombination occurs in the electron transport layer, resulting in lower open-circuit voltage and photoelectric conversion efficiency of the tandem solar cell.

### SUMMARY

This disclosure is made in view of the above issues and intended to provide a tandem solar cell, a photovoltaic module, a power generation apparatus, and an electric apparatus. In the tandem solar cell, arrangement of a first hole blocking layer and a second hole blocking layer can achieve multi-layer hole blocking in a first battery cell, which enhances the hole blocking effect, thereby increasing the open-circuit voltage and photoelectric conversion efficiency of the tandem solar cell.

To achieve the above purpose, a first aspect of this disclosure provides a tandem solar cell. The tandem solar cell includes a first electrode and a second electrode; at least a first battery cell and a second battery cell arranged in sequence in a first direction between the first electrode and the second electrode; and a composite layer arranged between the first battery cell and the second battery cell, the first direction being a direction of light incidence; where the first battery cell includes the following stacked layers: a first light absorption layer, a first electron transport layer, a first hole blocking layer arranged on a side of the first electron transport layer closer to the first light absorption layer, and a second hole blocking layer arranged on a side of the first electron transport layer farther away from the first light absorption layer, and the first light absorption layer includes a perovskite material. Arrangement of the first hole blocking layer and the second hole blocking layer can achieve multi-layer hole blocking in the first battery cell, which enhances the hole blocking effect, thus further reducing non-radiative recombination of holes and electrons, and increasing the open-circuit voltage and photoelectric conversion efficiency of the tandem solar cell.

In some embodiments, the second battery cell includes the following stacked layers: a second light absorption layer, a second electron transport layer, and a third hole blocking layer arranged between the second light absorption layer and the second electron transport layer. The blocking effect of the third hole blocking layer on holes is utilized to further reduce non-radiative recombination of electrons and holes.

In some embodiments, the first hole blocking layer includes a first hole blocking material, and a difference (σ) between a HOMO energy level of the first hole blocking material and a HOMO energy level of the perovskite material in the first light absorption layer is less than or equal to -0.1 eV. When σ is within the above range, the blocking effect of the first hole blocking layer on holes can be further enhanced.

In some embodiments, the third hole blocking layer includes a third hole blocking material, the second light absorption layer includes a second light absorption material, and a difference (ω) between a HOMO energy level of the third hole blocking material and a HOMO energy level of the second light absorption material is less than -0.1 eV. When ω is within the above range, the blocking effect of the third hole blocking layer on holes is further enhanced.

In some embodiments, a thickness of the first hole blocking layer is 5 nm to 20 nm. Controlling the thickness of the first hole blocking layer within the above range is beneficial for the first hole blocking layer to exert its hole blocking advantage while also reducing absorption of sunlight by the first hole blocking layer.

In some embodiments, the thickness of the first hole blocking layer is 5 nm to 16 nm. Controlling the thickness of the first hole blocking layer is beneficial for the tandem solar cell to further exert its advantages.

In some embodiments, a thickness of the third hole blocking layer is 5 nm to 20 nm. Controlling the thickness of the third hole blocking layer within the above range allows the hole blocking advantage thereof to be exerted and is also beneficial for reducing absorption of sunlight by the third hole blocking layer.

In some embodiments, the thickness of the third hole blocking layer is 5 nm to 10 nm. Controlling the thickness of the third hole blocking layer is beneficial for the tandem solar cell to further exert its advantages.

In some embodiments, the first battery cell is arranged on the first electrode and includes a first hole transport layer, the first light absorption layer, the first hole blocking layer, the first electron transport layer, and the second hole blocking layer that are arranged in sequence in the first direction; the second battery cell is arranged on the composite layer and includes a second hole transport layer, the second light absorption layer, the third hole blocking layer, and the second electron transport layer that are arranged in sequence in the first direction; and the second electrode is arranged on a side of the second electron transport layer farther away from the third hole blocking layer; where the second light absorption layer includes a perovskite material. Arrangement of the first hole blocking layer, the second hole blocking layer, and the third hole blocking layer can achieve multi-layer hole blocking, which enhances the hole blocking effect, thereby further increasing the open-circuit voltage and photoelectric conversion efficiency of the tandem solar cell.

In some embodiments, the first battery cell is arranged on the first electrode and includes a first hole transport layer, the first light absorption layer, the first hole blocking layer, the first electron transport layer, and the second hole blocking layer that are arranged in sequence in the first direction; the second battery cell is arranged on the composite layer and includes a second hole transport layer, the second light absorption layer, the third hole blocking layer, and the second electron transport layer that are arranged in sequence in the first direction, where the second battery cell further includes a fourth hole blocking layer arranged on a side of the second electron transport layer farther away from the third hole blocking layer and in contact with the second electron transport layer; and the second electrode is arranged on a side of the fourth hole blocking layer farther away from the second electron transport layer; where the second light absorption layer includes a perovskite material. Arrangement of the first hole blocking layer, the second hole blocking layer, the third hole blocking layer, and the fourth hole blocking layer can achieve multi-layer hole blocking, which enhances the hole blocking effect, thereby further increasing the open-circuit voltage and photoelectric conversion efficiency of the tandem solar cell.

In some embodiments, the first battery cell is arranged on the first electrode and includes the second hole blocking layer, the first electron transport layer, the first hole blocking layer, the first light absorption layer, and a first hole transport layer that are arranged in sequence in the first direction; the second battery cell is arranged on the composite layer and includes the second electron transport layer, the third hole blocking layer, the second light absorption layer, and a second hole transport layer that are arranged in sequence in the first direction; and the second electrode is arranged on the second hole transport layer and is in contact with the second hole transport layer; where the second light absorption layer includes a crystalline silicon material.

In some embodiments, the first hole blocking layer includes at least one of 2,9-dimethyl-4,7-diphenyl-1,10-phenanthroline, SnO₂, 1,3,5-tris(1-phenyl-1H-benzimidazol-2-yl)benzene, 1,3-bis[3,5-di(pyridin-3-yl)phenyl]benzene, diphenyl[4-(triphenylsilyl)phenyl]phosphine oxide, 2,7-bis(2,2'-bipyridin-5-yl)triphenylene, bis(8-hydroxy-2-methylquinolinato)-(4-phenylphenoxy)aluminum, [6-(1,10-phenanthrolin-3-yl)naphthalen-2-yl]diphenylphosphine oxide, 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, and bathophenanthroline. The above materials can block the migration of holes.

In some embodiments, the second hole blocking material may include at least one of fullerene and derivatives thereof, 2,9-dimethyl-4,7-diphenyl-1,10-phenanthroline, and SnO₂. The above materials can block the migration of holes.

In some embodiments, the third hole blocking layer includes at least one of 2,9-dimethyl-4,7-diphenyl-1,10-phenanthroline, SnO₂, 1,3,5-tris(1-phenyl-1H-benzimidazol-2-yl)benzene, 1,3-bis[3,5-di(pyridin-3-yl)phenyl]benzene, diphenyl[4-(triphenylsilyl)phenyl]phosphine oxide, 2,7-bis(2,2'-bipyridin-5-yl)triphenylene, bis(8-hydroxy-2-methylquinolinato)-(4-phenylphenoxy)aluminum, [6-(1,10-phenanthrolin-3-yl)naphthalen-2-yl]diphenylphosphine oxide, 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, bathophenanthroline, copper phthalocyanine, 8-hydroxyquinolinolato-lithium, BN-ICz-1, and 2,7-bis[N-(m-tolyl)anilino]-9,9'-spirobi[9H-fluorene]. The above materials can block the migration of holes.

In some embodiments, a HOMO energy level of the first light absorption layer of the first battery cell is lower than a HOMO energy level of the second light absorption layer of the second battery cell. The above arrangement is beneficial for the first battery cell and the second battery cell to form the tandem solar cell with high photoelectric conversion efficiency.

A second aspect of this disclosure provides a photovoltaic module, where the photovoltaic module includes the tandem solar cell provided according to the first aspect.

The photovoltaic module of this disclosure includes the tandem solar cell provided in this disclosure, and therefore has at least the same advantages as the tandem solar cell.

A third aspect of this disclosure provides a power generation apparatus, where the power generation apparatus includes the tandem solar cell according to the first aspect.

The power generation apparatus of this disclosure includes the tandem solar cell provided in this disclosure, and therefore has at least the same advantages as the tandem solar cell.

A fourth aspect of this disclosure provides an electric apparatus, where the electric apparatus includes the tandem solar cell according to the first aspect.

The electric apparatus of this disclosure includes the tandem solar cell provided by this disclosure, and therefore has at least the same advantages as the tandem solar cell.

### BRIEF DESCRIPTION OF DRAWINGS

FIG. 1 is a schematic structural diagram of a tandem solar cell according to an embodiment of this disclosure.
FIG. 2 is a schematic structural diagram of an all-perovskite tandem cell according to an embodiment of this disclosure.
FIG. 3 is a schematic structural diagram of an all-perovskite tandem cell according to an embodiment of this disclosure.
FIG. 4 is a schematic structural diagram of a perovskite-crystalline silicon tandem cell according to an embodiment of this disclosure.

Description of reference signs:
10, 100, 200, and 300: tandem solar cell; 11: first electrode; 12: second electrode; 13: first battery cell; 131: first hole transport layer; 132: first light absorption layer; 133: first hole blocking layer; 134: first electron transport layer; 135: second hole blocking layer; 14: second battery cell; 141: second hole transport layer; 142: second light absorption layer; 143: third hole blocking layer; 144: second electron transport layer; 145: fourth hole blocking layer; and 15: composite layer.

### DESCRIPTION OF EMBODIMENTS

Embodiments that specifically disclose a tandem solar cell, a photovoltaic module, a power generation apparatus, and an electric apparatus in this disclosure are described in detail below with reference to the accompanying drawings as appropriate. However, there may be cases where unnecessary detailed descriptions are omitted. For example, detailed descriptions of well-known matters and repeated descriptions of actually identical structures have been omitted. This is to avoid unnecessarily prolonging the following description, for ease of understanding by persons skilled in the art. In addition, the accompanying drawings and the following descriptions are provided for persons skilled in the art to fully understand this disclosure and are not intended to limit the subject matter recorded in the claims.

"Ranges" disclosed in this disclosure are defined in the form of lower limit and upper limit. A given range is defined by one lower limit and one upper limit selected, where the selected lower limit and upper limit defines boundaries of that particular range. Ranges defined in this method may or may not include end values, and any combinations may be used, meaning any lower limit may be combined with any upper limit to form a range. For example, if ranges of 60-120 and 80-110 are provided for a specific parameter, it is understood that ranges of 60-110 and 80-120 can also be envisioned. In addition, if low limit values of a range are given as 1 and 2, and upper limit values of the range are given as 3, 4, and 5, the following ranges can all be envisioned: 1-3, 1-4, 1-5, 2-3, 2-4, and 2-5. In this disclosure, unless otherwise stated, a value range of "a-b" is a short representation of any combination of real numbers between a and b, where both a and b are real numbers. For example, a value range of "0-5" means that all real numbers in the range of "0-5" are listed herein, and "0-5" is just a short representation of a combination of these values. In addition, a parameter expressed as an integer greater than or equal to 2 is equivalent to disclosure that the parameter is, for example, an integer among 2, 3, 4, 5, 6, 7, 8, 9, 10, 11, 12, and so on.

Unless otherwise specified, all the embodiments and optional embodiments of this disclosure can be combined with each other to form new technical solutions.

Unless otherwise specified, all the technical features and optional technical features of this disclosure can be combined with each other to form new technical solutions

Unless otherwise specified, all the steps in this disclosure can be performed sequentially or randomly, preferably, performed sequentially. For example, a method including steps (a) and (b) indicates that the method may include steps (a) and (b) performed sequentially, or may include steps (b) and (a) performed sequentially. For example, that the method may further include step (c) indicates that step (c) may be added to the method in any sequence. For example, the method may include steps (a), (b), and (c), or steps (a), (c), and (b), or steps (c), (a), and (b), or the like.

Unless otherwise specified, terms used in this disclosure have common meanings generally understood by persons skilled in the art.

Unless otherwise specified, numerical values of parameters mentioned in this disclosure may be measured by using various measurement methods commonly used in the art, for example, they may be tested by using the methods provided in this disclosure.

The term "layer" used in this disclosure refers to any structure that is substantially layered. A layer may have a thickness that varies within the range in which the layer extends. Generally, the thickness of a layer is approximately constant. The "thickness" of a layer used in this disclosure refers to an average thickness of the layer. The thickness of a layer can be easily measured using conventional methods.

Unless otherwise specified, reference in this disclosure to that one layer is/located on another layer includes a case in which a first layer is directly located on a second layer, that is, the two layers are in direct contact, and a case in which there is another layer (such as a third layer) interposed between the first layer and the second layer.

The term "perovskite" used in this disclosure refers to a material having a three-dimensional crystal structure related to the three-dimensional crystal structure of CaTiO₃, or a layer material including a structure related to the structure of CaTiO₃. Materials having a three-dimensional crystal structure related to the three-dimensional crystal structure of CaTiO₃ are well known and may be referred to as perovskites having a "3D perovskite structure" or "3D perovskites". Materials including a perovskite material layer are well known and referred to in the art as "2D layered perovskites". When exposed to sunlight, electrons in the perovskite are excited, and the electrons transition from the valence band to the conduction band, generating electron-hole pairs. Unless otherwise specified, "perovskite" mentioned in this disclosure refers to a 3D perovskite material. The perovskite chemical formula may be expressed as ABX₃, where A is generally a cation with a larger radius. For example, A includes at least one of CH(NH₂)₂⁺, CH₃NH₃⁺, K⁺, Rb⁺, and Cs⁺. B is a cation with a smaller radius, and B includes but is not limited to at least one of Pb²⁺, Sn²⁺, Mg²⁺, Ca²⁺, Ba²⁺, Zn²⁺, Ge²⁺, and Co²⁺. X is an anion. For example, X includes at least one of Cl⁻, Br⁻, I⁻, SCN⁻, CNO⁻, OCN⁻, OSCN⁻, SH⁻, OH⁻, CP⁻, CN⁻, and SeCN⁻. When the perovskite includes more than one type of A cations, different A cations may be distributed in an ordered or disordered manner on the A-sites. When the perovskite includes more than one type of B cations, different B cations may be distributed in an ordered or disordered manner on the B-sites. When the perovskite includes more than one type of X anions, different X anions may be distributed in an ordered or disordered manner on the X-sites.

Solar cells, also known as photovoltaic cells, are apparatuses that directly convert light energy into electrical energy through the photoelectric or photochemical effect. As an ideal renewable energy source, solar cells are receiving increasing attention.

With the development of solar cell technologies, higher requirements are posed on performance of the solar cells. A tandem solar cell includes at least two battery cells arranged in a stacked configuration. Through the combination of band gaps of each battery cell, absorption of sunlight in a long wavelength range is realized, and the utilization rate of sunlight is improved. Therefore, tandem solar cells have high photoelectric conversion efficiency.

In a tandem solar cell, each battery cell is provided with a light absorption layer and a charge carrier transport layer (for example, an electron transport layer and a hole transport layer). The light absorption layer uses a light absorption material (for example, a perovskite material) that can absorb photons to generate electron-hole pairs. Under the action of an electric field, the electron-hole pairs are dissociated into charge carriers (electrons and holes). The directional movement of the dissociated charge carriers forms a current. The presence of the charge carrier transport layer can enhance the dissociation effect of electrons and holes, thereby effectively improving the photoelectric conversion efficiency of the cell.

Electrons and holes dissociated from the light absorption layer are prone to non-radiative recombination, which affects the photoelectric conversion efficiency of the tandem cell. To further improve the photoelectric conversion efficiency of the tandem cell, it has been proposed to arrange a hole blocking layer between the electron transport layer and the composite layer of a first battery cell (the first battery cell arranged in an incident direction), which can reduce non-radiative recombination of electrons and holes and improve the photoelectric conversion efficiency.

To further improve the photoelectric conversion efficiency of tandem cells, especially perovskite tandem cells, it has been found that defects are prone to occur at grain boundaries of a perovskite light absorption layer. These defects limit further improvement of photoelectric conversion efficiency. Therefore, it has been proposed to arrange a passivation layer on a surface of the perovskite light absorption layer. However, the inventors have found through research that in a perovskite tandem cell, even if a hole blocking layer is arranged between an electron transport layer and a composite layer and a passivation layer is arranged on a surface of a perovskite light absorption layer, non-radiative recombination of holes and electrons still exists. Therefore, there is still room for improvement in the photoelectric conversion efficiency of the tandem cell.

Based on this, this disclosure provides a tandem solar cell, and a photovoltaic module, a power generation apparatus, and an electric apparatus including the tandem solar cell.

### Tandem solar cell

The tandem solar cell provided in this disclosure includes a first electrode and a second electrode; at least a first battery cell and a second battery cell arranged in sequence in a first direction between the first electrode and the second electrode; and a composite layer arranged between the first battery cell and the second battery cell, the first direction being a direction of light incidence; where the first battery cell includes the following stacked layers: a first light absorption layer, a first electron transport layer, a first hole blocking layer arranged on a side of the first electron transport layer closer to the first light absorption layer, and a second hole blocking layer arranged on a side of the first electron transport layer farther away from the first light absorption layer, and the first light absorption layer includes a perovskite material.

The following further describes various aspects of the tandem solar cell of this disclosure with reference to the accompanying drawings.

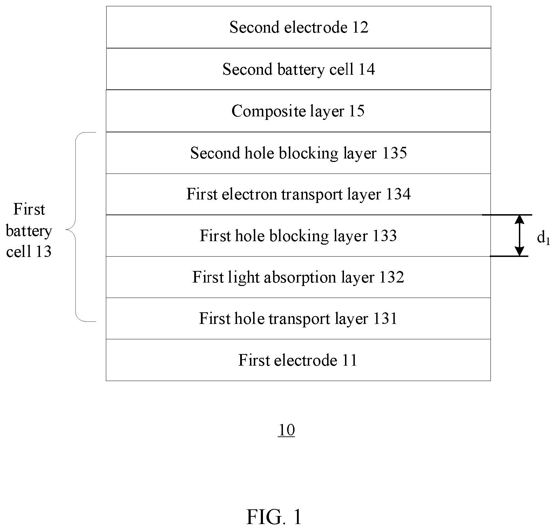

FIG. 1 is a schematic diagram of a tandem solar cell according to an embodiment of this disclosure. As shown in FIG. 1, the tandem solar cell 10 includes: a first electrode 11 and a second electrode 12; at least a first battery cell 13 and a second battery cell 14 arranged in sequence in a first direction between the first electrode 11 and the second electrode 12; and a composite layer 15 arranged between the first battery cell 13 and the second battery cell 14, the first direction being a direction of light incidence; where the first battery cell 13 includes a first hole blocking layer 133 arranged between a first light absorption layer 132 and a first electron transport layer 134, the first battery cell 13 further includes a second hole blocking layer 135 arranged on a side of the first electron transport layer 134 farther away from the first light absorption layer 132 and in contact with the first electron transport layer 134, and the first light absorption layer 132 includes a perovskite material.

In this disclosure, arrangement of the first hole blocking layer 133 and the second hole blocking layer 135 can achieve multi-layer hole blocking in the first battery cell 13, which enhances the hole blocking effect, thus further reducing non-radiative recombination of holes and electrons, and increasing the open-circuit voltage and photoelectric conversion efficiency of the tandem solar cell.

Generally, because it is recognized that a light absorption layer containing a perovskite material is prone to defects at grain boundaries of the perovskite material, a passivation layer is usually provided between the light absorption layer and the electron transport layer. However, in such structure, non-radiative recombination of holes and electrons still exists, especially in the first battery cell 13 of a tandem cell. In the tandem solar cell proposed in this disclosure, a first hole blocking layer 133 is used instead of a conventional passivation layer between the first light absorption layer 132 and the first electron transport layer 134, unexpectedly achieving improvement in photoelectric conversion efficiency.

The term "tandem solar cell" in this disclosure refers to a solar cell having a structure in which at least two battery cells are arranged in sequence in a direction of light incidence. Stacking of at least two battery cells can increase the utilization rate of incident sunlight.

The number of battery cells included in the tandem solar cell 10 is not particularly limited in this disclosure. For example, the number of battery cells included in the tandem solar cell may be 2, 3, 4, or the like.

In the following text, that the tandem solar cell 10 includes two battery cells (the first battery cell 13 and the second battery cell 14) is used as an example for description.

The first electrode 11, which may also be referred to as a bottom electrode, refers to an electrode that receives incident light first and is used to collect electrons/holes. A material used for the first electrode 11 includes a transparent conductive material. The transparent conductive material included in the first electrode 11 is not particularly limited in this disclosure. For example, the transparent conductive material includes at least one of tin oxide, indium tin oxide (ITO), fluorine-doped tin oxide (FTO), indium-doped zinc oxide (IZO), aluminum-doped zinc oxide (AZO), boron-doped zinc oxide (BZO), antimony-doped tin oxide, and indium-doped tungsten oxide.

The second electrode 12, which may also be referred to as a top electrode, refers to an electrode that receives incident light last and is used to collect electrons/holes. A material used for the second electrode 12 includes a conductive material. The conductive material included in the second electrode 12 is not particularly limited in this disclosure. For example, the conductive material includes at least one of an organic conductive material and an inorganic conductive material, where the inorganic conductive material includes at least one of the above transparent conductive material, metal and alloy thereof, and an elemental carbon material. For example, the metal and alloy thereof include at least one of gold, silver, copper, aluminum, nickel, chromium, bismuth, platinum, magnesium, molybdenum, and tungsten. For example, the elemental carbon material includes at least one of graphite, graphene, and carbon nanotubes. For example, the organic conductive material includes at least one of poly(3,4-ethylenedioxythiophene), polythiophene, and polyacetylene.

The composite layer 15 is arranged between the first battery cell 13 and the second battery cell and is used to provide a site for the recombination of electrons generated by excitation in the first light absorption layer 132 and holes generated by excitation in the second light absorption layer 142. A material included in the composite layer 15 is not particularly limited in this disclosure. For example, the composite layer 15 includes at least one of gold, platinum, indium tin oxide, indium zinc oxide, iron, cobalt, nickel, zinc, manganese, cadmium, silver, and copper. A thickness of the composite layer 15 is not particularly limited in this disclosure, and a thickness commonly used for a composite layer in the art may be used.

In this disclosure, the first light absorption layer 132 of the first battery cell 13 includes a perovskite material. Through the design of the perovskite material, the first light absorption layer 132 can have a wider band gap (for example, a band gap of 1.6 eV-2.3 eV), which is beneficial for the first battery cell 13 and the second battery cell 14 with a narrow band gap to form the tandem solar cell 10 with high photoelectric conversion efficiency.

A material (second light absorption material) used for the second light absorption layer arranged in the second battery cell 14 is not particularly limited in this disclosure, provided that the material can absorb photons to generate electron-hole pairs. For example, the second light absorption material includes at least one of a crystalline silicon material, a perovskite material, and a heterojunction. In this disclosure, a tandem solar cell in which the second light absorption material includes a perovskite material may also be referred to as an all-perovskite tandem cell. A tandem solar cell in which the second light absorption material includes a crystalline silicon material may also be referred to as a perovskite-crystalline silicon tandem cell.

The first battery cell 13 includes a first hole transport layer 131, the first light absorption layer 132, the first hole blocking layer 133, the first electron transport layer 134, and the second hole blocking layer 135 that are arranged on the first electrode 11.

The first hole transport layer 131 includes a hole transport material. The hole transport material included in the first hole transport layer 131 is not particularly limited in this disclosure. For example, the first hole transport layer 131 includes at least one of an inorganic hole transport material and an organic hole transport material. For example, the inorganic hole transport material includes at least one of metal oxides and copper thiocyanate. For example, the metal oxides include tin oxide (SnOₓ, where 1 < x < 2), nickel oxide (NiOₓ, where 1 ≤ x ≤ 2), and copper oxide (Cu₂O). For example, the organic hole transport material includes at least one of [2-(3,6-dimethoxy-9H-carbazol-9-yl)butyl]phosphoric acid, poly(3,4-ethylenedioxythiophene), poly(styrenesulfonate), polystyrene sulfonic acid, poly(3-hexylthiophene), triptycene-based triphenylamine, 3,4-ethylenedioxythiophene-methoxy triphenylamine, N-(4-aniline)carbazole-spirobifluorene, and polythiophene.

A thickness of the first hole transport layer 131 is not particularly limited in this disclosure, and a thickness commonly used for a hole transport layer in the art may be used.

The first light absorption layer 132 is arranged on the first hole transport layer 131, is in contact with the first hole transport layer 131, and includes a perovskite material. To improve the photoelectric conversion efficiency, the perovskite material (hereinafter may be referred to as a first perovskite material) included in the first light absorption layer 132 is designed to have a wider band gap. For example, the band gap of the first perovskite material is 1.6 eV-2.3 eV. The first perovskite material is well known to persons skilled in the art. For example, the first perovskite material is, for example, FA_{0.8}Cs_{0.2}Pb(I_{0.6}Br_{0.4})₃, FA_{0.15}Cs_{0.85}Pb(I_{0.73}Br_{0.27})₃, or Cs_{0.12}MA_{0.05}FA_{0.83}Pb(I_{0.6}Br_{0.4})₃.

A thickness of the first light absorption layer 132 is not particularly limited in this disclosure, and a thickness commonly used for a light absorption layer in the art may be used.

The first electron transport layer 134 is arranged on a side of the first light absorption layer 132 farther away from the first hole transport layer 131 and includes an electron transport material. The electron transport material included in the first electron transport layer 134 is not particularly limited in this disclosure. For example, the electron transport material includes at least one of fullerene and derivatives thereof (for example, C₆₀), metal oxides (such as oxides containing at least one of magnesium, cadmium, zinc, indium, lead, tungsten, bismuth, mercury, titanium, silver, manganese, iron, and vanadium), silicon oxide, strontium titanate, calcium titanate, lithium fluoride, and calcium fluoride.

A thickness of the first electron transport layer 134 is not particularly limited in this disclosure, and a thickness commonly used for an electron transport layer in the art may be used.

The first hole blocking layer 133 is arranged between the first light absorption layer 132 and the first electron transport layer 134 and is used to prevent holes dissociated from the first light absorption layer 132 from being transported to a side of the first electron transport layer 134.

The first hole blocking layer 133 includes a first hole blocking material. A conventional hole blocking material may be used as the first hole blocking material, but needs to satisfy a requirement that a difference (σ) between a HOMO energy level of the first hole blocking material and a HOMO energy level of the first perovskite material is less than 0.

In some embodiments, the first hole blocking material is selected from at least one of 2,9-dimethyl-4,7-diphenyl-1,10-phenanthroline (BCP), SnO₂, 1,3,5-tris(1-phenyl-1H-benzimidazol-2-yl)benzene (TPBI), 1,3-bis[3,5-di(pyridin-3-yl)phenyl]benzene (B3PyPB), diphenyl[4-(triphenylsilyl)phenyl]phosphine oxide (TSPO1), 2,7-bis(2,2'-bipyridin-5-yl)triphenylene (BPy-TP2), bis(8-hydroxy-2-methylquinolinato)-(4-phenylphenoxy)aluminum, [6-(1,10-phenanthrolin-3-yl)naphthalen-2-yl]diphenylphosphine oxide (Phen-NaDPO), 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, and bathophenanthroline.

It has been found in this disclosure that these materials can be used in perovskite solar cells and can effectively improve the open-circuit voltage. It is speculated that they have both the function of hole blocking and the effect of passivating the perovskite light absorption layer.

Therefore, in some embodiments, the first hole blocking material is selected from at least one of BCP, TPBI, B3PyPB, TSPO1, BPy-TP2, bis(8-hydroxy-2-methylquinolinato)-(4-phenylphenoxy)aluminum, Phen-NaDPO, 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, and bathophenanthroline. The above materials can not only block the migration of holes, but also passivate the A-site of the perovskite material, thereby featuring the dual effect of reducing defects at grain boundaries of the perovskite material in the first light absorption layer 132 and blocking non-radiative recombination of holes and electrons.

The applicant has found that the blocking effect of the first hole blocking layer 133 on holes is related to σ. A larger absolute value of σ leads to stronger blocking effect of the first hole blocking layer 133 on holes.

In some embodiments, the difference σ between the HOMO energy level of the first hole blocking material and the HOMO energy level of the perovskite material in the first light absorption layer is less than or equal to -0.1 eV. For example, σ is -0.1 eV, -0.11 eV, -0.12 eV, -0.13 eV, -0.14 eV, -0.15 eV, or a value in a range defined by any two of the above values, but is not limited thereto. When σ is within the above range, the blocking effect of the first hole blocking layer 133 on holes can be further improved.

In some embodiments, a thickness (d₁) of the first hole blocking layer 133 is 5 nm to 20 nm. Optionally, d₁ is 5 nm to 16 nm. For example, the thickness of the first hole blocking layer is 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, or a value in a range defined by any two of the above values, but is not limited thereto. Controlling the thickness of the first hole blocking layer 133 within the above ranges is beneficial for the first hole blocking layer 133 to exert its hole blocking advantage and also beneficial for reducing absorption of sunlight by the first hole blocking layer 133.

The second hole blocking layer 135 is arranged on the first electron transport layer 134. The second hole blocking layer 135 includes a second hole blocking material. The second hole blocking material is not particularly limited in this disclosure. For example, the second hole blocking material may include at least one of fullerene and derivatives thereof, BCP, and SnO₂. For example, fullerene and derivatives thereof include at least one of PCBM and C₆₀.

In some embodiments, the second battery cell includes the following stacked layers: a second light absorption layer, a second electron transport layer, and a third hole blocking layer arranged between the second light absorption layer and the second electron transport layer. The blocking effect of the third hole blocking layer on holes is utilized to further reduce non-radiative recombination of electrons and holes.

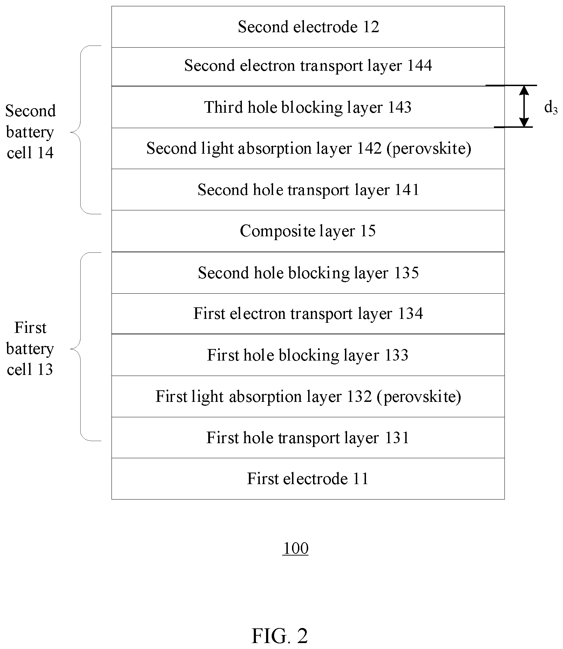

Referring to a tandem solar cell (all-perovskite tandem cell) 100 shown in FIG. 2, in this embodiment, a first battery cell 13 is arranged on a first electrode 11 and includes a first hole transport layer 131, a first light absorption layer 132, a first hole blocking layer 133, a first electron transport layer 134, and a second hole blocking layer 135 that are arranged in sequence in a first direction; a second battery cell 14 is arranged on a composite layer 15 and includes a second hole transport layer 141, a second light absorption layer 142, a third hole blocking layer 143, and a second electron transport layer 144 that are arranged in sequence in the first direction; and the second electrode 12 is arranged on a side of the second electron transport layer 144 farther away from the third hole blocking layer 143; where the second light absorption layer 142 includes a perovskite material.

In this embodiment, the first battery cell 13, the first electrode 11, the second electrode 12, and the composite layer 15 are the same as those in the foregoing embodiments. Details are not repeated herein.

The second hole transport layer 141 includes a hole transport material. The hole transport material included in the second hole transport layer 141 is not particularly limited in this disclosure. Specific examples of the hole transport material included in the second hole transport layer 141 are the same as the hole transport material in the first hole transport layer in the foregoing embodiments. Details are not repeated herein.

A thickness of the second hole transport layer 141 is not particularly limited in this disclosure, and a thickness commonly used for a hole transport layer in the art may be used.

The second light absorption layer 142 includes a light absorption material (hereinafter referred to as a second light absorption material).

In this embodiment, the second light absorption material includes a perovskite material. The perovskite material has high photoelectric conversion efficiency. The use of the second light absorption layer including a perovskite material is beneficial for further improving the photoelectric conversion efficiency of the tandem cell. In some embodiments, a band gap of the perovskite material in the first light absorption layer 132 is wider than a band gap of the perovskite material in the second light absorption layer 142. For example, the band gap of the perovskite material included in the first light absorption layer 132 is 1.6 eV-2.3 eV, and the band gap of the perovskite material included in the second light absorption layer 142 is 1.1 eV-1.4 eV. For example, the perovskite material included in the second light absorption layer 142 is, for example, MA_{0.3}FA_{0.7}Pb_{0.5}Sn_{0.5}I₃, MAPb_{0.85}Sn_{0.15}I₃, FAPb_{0.5}Sn_{0.5}I₃, or FA_{0.7}MA_{0.3}Pb_{0.5}Sn_{0.5}I₃.

A thickness of the second light absorption layer 142 is not particularly limited in this disclosure, and a thickness commonly used for a light absorption layer in the art may be used.

The second electron transport layer 144 includes an electron transport material. The electron transport material included in the second electron transport layer 144 is not particularly limited in this disclosure. Specific examples of the electron transport material included in the second electron transport layer 144 are the same as those in the foregoing embodiments. Details are not repeated herein.

A thickness of the second electron transport layer 144 is not particularly limited in this disclosure, and a thickness commonly used for an electron transport layer in the art may be used.

The third hole blocking layer 143 is arranged between the second light absorption layer 142 and the second electron transport layer 144 and is used to prevent holes dissociated from the second light absorption layer 142 from being transported to a side of the second electron transport layer 144. The third hole blocking layer 143 includes a third hole blocking material. A conventional hole blocking material may be used as the third hole blocking material, but needs to satisfy a requirement that a difference (ω) between a HOMO energy level of the third hole blocking material and a HOMO energy level of the second light absorption material is less than 0. In some embodiments, the third hole blocking material may be the same as the first hole blocking material.

In some embodiments, the third hole blocking material is selected from at least one of 2,9-dimethyl-4,7-diphenyl-1,10-phenanthroline (BCP), SnO₂, 1,3,5-tris(1-phenyl-1H-benzimidazol-2-yl)benzene (TPBI), 1,3-bis[3,5-di(pyridin-3-yl)phenyl]benzene (B3PyPB), diphenyl[4-(triphenylsilyl)phenyl]phosphine oxide (TSPO1), 2,7-bis(2,2'-bipyridin-5-yl)triphenylene (BPy-TP2), bis(8-hydroxy-2-methylquinolinato)-(4-phenylphenoxy)aluminum, [6-(1,10-phenanthrolin-3-yl)naphthalen-2-yl]diphenylphosphine oxide (Phen-NaDPO), 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, bathophenanthroline, copper phthalocyanine (CuPc), 8-hydroxyquinolinolato-lithium (Liq), BN-ICz-1 (C₅₀H₄₀BN₃), and 2,7-bis[N-(m-tolyl)anilino]-9,9'-spirobi[9H-fluorene] (C₅₁H₃₈N₂).

The chemical formula of BN-ICz-1 is

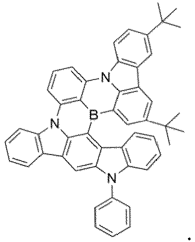

In some embodiments, the third hole blocking material is selected from at least one of BCP, TPBI, B3PyPB, TSPO1, BPy-TP2, bis(8-hydroxy-2-methylquinolinato)-(4-phenylphenoxy)aluminum, Phen-NaDPO, 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, bathophenanthroline, CuPc, 8-hydroxyquinolinolato-lithium, and BN-ICz-1. Similarly, the above materials can not only block the migration of holes, but also passivate the A-site of the perovskite material, thereby featuring the dual effect of reducing defects at grain boundaries of the perovskite material in the second light absorption layer 142 and blocking non-radiative recombination of electrons and holes.

The applicant has found that the blocking effect of the third hole blocking layer 143 on holes is related to ω. A larger absolute value of ω leads to stronger blocking effect of the third hole blocking layer 143 on holes.

In some embodiments, the difference ω between the HOMO energy level of the third hole blocking material and the HOMO energy level of the second light absorption material is less than or equal to -0.1 eV. For example, ω is -0.11 eV, -0.12 eV, -0.13 eV, -0.14 eV, -0.15 eV, or a value in a range defined by any two of the above values, but is not limited thereto. When ω is within the above range, the blocking effect of the third hole blocking layer 143 on holes is further enhanced.

In some embodiments, d₃ is 5 nm to 20 nm. Optionally, d₃ is 5 nm to 10 nm, 6 nm to 10 nm, 6 nm to 8 nm, and so on. For example, d₃ is 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, or a value in a range defined by any two of the above values, but is not limited thereto. Controlling the thickness of the third hole blocking layer 143 within the above ranges allows the hole blocking advantage thereof to be exerted and is also beneficial for reducing absorption of sunlight by the third hole blocking layer 143. This is advantageous for a tandem solar cell with more battery cells.

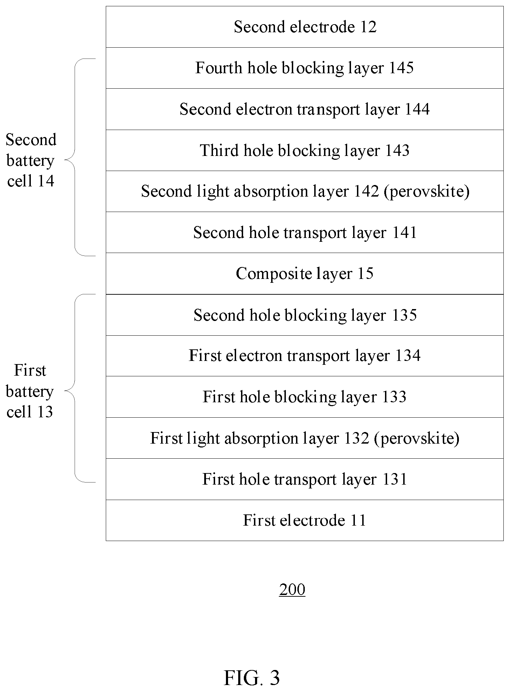

Referring to a tandem solar cell (all-perovskite tandem cell) 200 shown in FIG. 3, in this embodiment, a first battery cell 13 is arranged on a first electrode 11 and includes a first hole transport layer 131, a first light absorption layer 132, a first hole blocking layer 133, a first electron transport layer 134, and a second hole blocking layer 135 that are arranged in sequence in a first direction; a second battery cell 14 is arranged on a composite layer 15 and includes a second hole transport layer 141, a second light absorption layer 142, a third hole blocking layer 143, and a second electron transport layer that are arranged in sequence in the first direction; and the second battery cell 14 further includes a fourth hole blocking layer 145 arranged on a side of the second electron transport layer 144 away from the third hole blocking layer 143 and in contact with the second electron transport layer 144, and the second electrode 12 is arranged on a side of the fourth hole blocking layer 145 away from the second electron transport layer 144; where the second light absorption layer 142 includes a perovskite material. The tandem solar cell 200 in this embodiment has a structure differs from that of the tandem solar cell 100 in the foregoing embodiment in that it has the fourth hole blocking layer 145. Arrangement of the first hole blocking layer 133, the second hole blocking layer 135, the third hole blocking layer 143, and the fourth hole blocking layer 145 can achieve multi-layer hole blocking, which enhances the hole blocking effect, thereby further increasing the open-circuit voltage and photoelectric conversion efficiency of the tandem solar cell 200.

The fourth hole blocking layer 145 includes a fourth hole blocking material. The fourth hole blocking material is not particularly limited in this disclosure. For example, the fourth hole blocking material may include at least one of fullerene and derivatives thereof, SnO₂, and bathocuproine (BCP). For example, fullerene and derivatives thereof are, for example, PCBM and C₆₀. The fourth hole blocking material may be the same as or different from the second hole blocking material.

The other layers are the same as those in the foregoing embodiments. Details are not repeated herein.

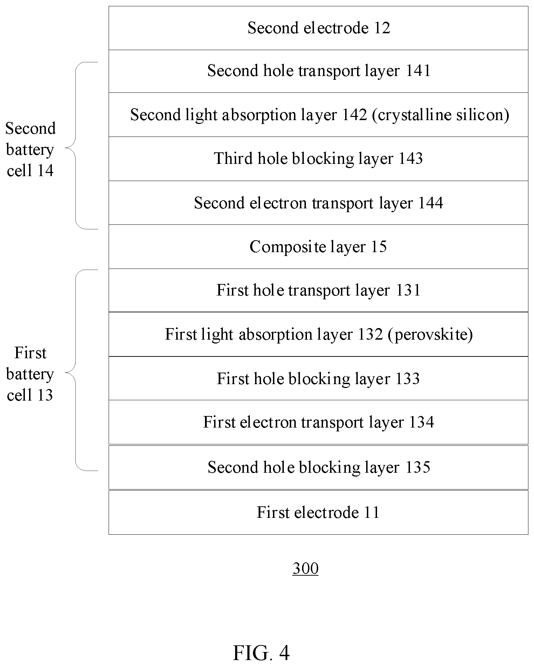

Referring to a tandem solar cell (perovskite-crystalline silicon tandem cell) 300 shown in FIG. 4, in this embodiment, a first battery cell 13 is arranged on a first electrode 11 and includes a second hole blocking layer 135, a first electron transport layer 134, a first hole blocking layer 133, a first light absorption layer 132, and a first hole transport layer 131 that are arranged in sequence in a first direction; a second battery cell 14 is arranged on a composite layer 15 and includes a second electron transport layer 144, a third hole blocking layer 143, a second light absorption layer 142, and a second hole transport layer 141 that are arranged in sequence in the first direction; and the second electrode 12 is arranged on a side of the second hole transport layer 141 farther away from the second light absorption layer 142; where the second light absorption layer 142 arranged in the second battery cell includes a crystalline silicon material. For example, the crystalline silicon material includes monocrystalline silicon.

The rest layers are the same as those in the foregoing embodiments. Details are not repeated herein.

In the tandem solar cell of this disclosure, the first battery cell is a perovskite battery cell, the perovskite material is used as the first light absorption layer, and the second battery cell may be a perovskite battery cell or another battery cell, where the second light absorption layer may be a perovskite material, a crystalline silicon material, a heterojunction, or the like. Details are not described herein.

A preparation method of each functional layer of the foregoing tandem solar cell is not particularly limited in this disclosure, and may include preparation methods commonly used in the art. For example, the foregoing functional layers are formed by using methods including evaporation, atomic layer deposition, spin coating, and the like.

An embodiment of this disclosure further provides a photovoltaic module. Generally, the photovoltaic module includes the foregoing tandem solar cell, a solder ribbon connecting multiple tandem solar cells, a junction box for current transmission, and a cell encapsulation component.

In some embodiments, the cell encapsulation component includes photovoltaic glass, where the photovoltaic glass covers the foregoing tandem solar cell and protects the tandem solar cell. In addition, the photovoltaic glass has very good light transmittance and high hardness, and can adapt to large day-night temperature differences and harsh weather environments.

In some embodiments, the cell encapsulation component includes an ethylene-vinyl acetate copolymer (EVA) film arranged between the photovoltaic glass and the tandem solar cell and used to bond the photovoltaic glass and the solar cell.

In some embodiments, the cell encapsulation component includes a photovoltaic backsheet, where the photovoltaic backsheet also protects the tandem solar cell.

Optionally, a material of the photovoltaic backsheet may be a polyvinyl fluoride composite film or a thermoplastic elastomer material. The material of the photovoltaic backsheet has the characteristics of insulation, waterproofing, and aging resistance.

In some embodiments, the cell encapsulation component includes a solar aluminum frame, which includes an aluminum alloy material and has the characteristics of high strength and good corrosion resistance, and can provide support and protection for the solar cell.

An embodiment of this disclosure further provides a power generation apparatus including the tandem solar cell provided in the foregoing embodiments.

An embodiment of this disclosure further provides an electric apparatus including the tandem solar cell provided in the foregoing embodiments.

In some embodiments, the electric apparatus may also be a lighting device, an energy storage device, or the like, which is included in the embodiments of this disclosure but is not limited thereto. For example, the electric apparatus may be a solar water heater, a solar street light, a solar photovoltaic generator, or the like.

### Examples

The following describes examples of this disclosure. The examples below are illustrative and only used for explaining this disclosure, and cannot be construed as limitations on this disclosure. Unless otherwise specified, all reagents used are commercially available, and all equipment used is conventional equipment.

The applicant has tested the PLQY and open-circuit voltage loss of perovskite devices with passivation layers and hole blocking layers, and found that even if a hole blocking layer is arranged between an electron transport layer and a composite layer and a passivation layer is arranged on a surface of a perovskite light absorption layer, non-radiative recombination of holes and electrons still exists.

Preparation of samples under test:

### Sample 1 (hole transport layer/perovskite light absorption layer)

(1) Provision of a hole transport layer: FTO conductive glass after ultraviolet ozone treatment was spin-coated with a 15 mg/mL NiOₓ (1 ≤ x ≤ 2) nanoparticle aqueous solution in a glove box at a rate of 2000 rpm/s to have a hole transport layer formed with a thickness of 30 nm, and then thermally annealed at 150°C for 10 min.
(2) Provision of a perovskite light absorption layer: 1659 mg of lead iodide, 880 mg of lead bromide, 240 mg of formamidinium bromide, 495 mg of formamidinium iodide, 187 mg of cesium iodide, and 102 mg of cesium bromide were weighed and dissolved in 1 mL of a mixed solution of N,N-dimethylformamide (DMF) and dimethyl sulfoxide (DMSO) (a volume ratio of DMF to DMSO was 4:1). After stirred for 1 h, the mixture was filtered with a 0.22 µm organic filter membrane to obtain a perovskite precursor solution. 100 µL of the perovskite precursor solution was taken, and the hole transport layer was spin-coated with the perovskite precursor solution at 5000 rpm, then placed in a vacuum flash evaporation device for 30s, and transferred to a hot stage at 100°C for annealing for 10 min to have a perovskite light absorption layer (FA_{0.8}Cs_{0.2}Pb(I_{0.6}Br_{0.4})₃) formed with a thickness of 500 nm.

### Sample 2 (hole transport layer/perovskite light absorption layer/passivation layer/electron transport layer/hole blocking layer)

(1) Provision of a hole transport layer: FTO conductive glass after ultraviolet ozone treatment was spin-coated with a 15 mg/mL NiOₓ (1 ≤ x ≤ 2) nanoparticle aqueous solution in a glove box at a rate of 2000 rpm/s to have a hole transport layer formed with a thickness of 30 nm, and then thermally annealed at 150°C for 10 min.
(2) Provision of a perovskite light absorption layer: 1659 mg of lead iodide, 880 mg of lead bromide, 240 mg of formamidinium bromide, 495 mg of formamidinium iodide, 187 mg of cesium iodide, and 102 mg of cesium bromide were weighed and dissolved in 1 mL of a mixed solution of N,N-dimethylformamide (DMF) and dimethyl sulfoxide (DMSO) (a volume ratio of DMF to DMSO was 4:1). After stirred for 1 h, the mixture was filtered with a 0.22 µm organic filter membrane to obtain a perovskite precursor solution. 100 µL of the perovskite precursor solution was taken, and the hole transport layer was spin-coated with the perovskite precursor solution at 5000 rpm, then placed in a vacuum flash evaporation device for 30s, and transferred to a hot stage at 100°C for annealing for 10 min to have a perovskite light absorption layer (FA_{0.8}Cs_{0.2}Pb(I_{0.6}Br_{0.4})₃) formed with a thickness of 500 nm.
(3) Provision of a passivation layer: 100 µL of a phenethylamine iodide (5 mg/mL) isopropanol solution was taken, and the perovskite light absorption layer was spin-coated with the solution at a spin-coating speed of 4000 rpm and an acceleration of 1000 rpm/s for 25s, and annealed for 5 min to have a passivation layer formed with a thickness of 10 nm.
(4) Provision of an electron transport layer: C₆₀ with a thickness of 20 nm was evaporated on the above passivation layer as an electron transport layer.
(5) Provision of a hole blocking layer: SnO₂ with a thickness of 20 nm was deposited on the above electron transport layer by atomic layer deposition as a hole blocking layer.

### Testing of photoluminescence quantum yield (PLQY) and open-circuit voltage loss of the foregoing samples

(1) To test the PLQY of the test samples (Sample 1 and Sample 2), a photoluminescence fluorescence spectrometer (PLS980, Edinburgh Instruments) was used to test the PLQY of Sample 1 and Sample 2 respectively. During the test, for the samples under the irradiation of the reflected light from the excitation light source, electrons transitioned from the valence band to the conduction band and left holes in the valence band; electrons and holes reached their respective unoccupied lowest excited states through relaxation in their respective conduction and valence bands, entering quasi-equilibrium states; and electrons and holes in the quasi-equilibrium state recombined and emitted light to form a spectrum of light intensity or energy distribution of different wavelengths. The PLQY of the sample was obtained based on the spectrum. The test results are shown in Table 1.
(2) Calculation of open-circuit voltage loss of the samples

The open-circuit voltage loss (Δ*Voc nrad* ) caused by non-radiative recombination was calculated based on formula (I). The calculation results are shown in Table 1. $Δ Voc nrad = - \frac{kT}{q} Ln \left(PLQY\right)$ formula (I);

In the formula, k represents the Boltzmann constant, T represents the temperature, q represents the elementary charge, and PLQY represents the photoluminescence quantum yield.

**Table 1**

| No. | PLQY (%) | *ΔVoc nrad* (mV) |
|---|---|---|
| Sample 1 | 0.0125448 | 113.1829077 (*ΔVoc nrad*1) |
| Sample 2 | 0.000537716 | 194.6034535 (*ΔVoc nrad*2) |

In Table 1, Δ*Voc nrad*1 represents the open-circuit voltage loss caused by non-radiative recombination of electrons and holes at the interface between the hole transport layer and the perovskite light absorption layer and within the bulk phase of the perovskite light absorption layer.

Δ*Voc nrad*2 represents the open-circuit voltage loss caused by non-radiative recombination of electrons and holes at the interface between the hole transport layer and the perovskite light absorption layer, the bulk phase of the perovskite light absorption layer, the interface between the perovskite light absorption layer and the passivation layer, and the interface between the passivation layer and the electron transport layer.

The above results show that as compared with the structure in which only the hole transport layer and the perovskite light absorption layer exist, even if a hole blocking layer is arranged on the side of the electron transport layer farther away from the perovskite light absorption layer and a passivation layer is arranged on the surface of the perovskite light absorption layer, non-radiative recombination of holes and electrons may still exist, thereby causing an open-circuit voltage loss of about 80 mV (Δ*Voc nrad*2 - ΔΔ*Voc nrad*1).

In this disclosure, the conventional passivation layer is replaced with the foregoing first hole blocking layer, which increases the open-circuit voltage and photoelectric conversion effect. The following further describes this disclosure with reference to examples.

### Example 1

### Preparation of tandem solar cell (all-perovskite tandem cell):

(1) Provision of a first electrode: FTO conductive glass with a specification of 2.0×2.0 cm was taken; the FTO at both ends was removed by laser etching for 0.35 cm each to expose the glass substrate; the etched FTO conductive glass was ultrasonically cleaned with cleaning solution, deionized water, and ethanol in sequence; and the FTO conductive glass was dried with a nitrogen gun to remove the solvent and then placed in an ultraviolet ozone machine for further cleaning.
(2) Provision of a first hole transport layer: The FTO conductive glass after ultraviolet ozone treatment was spin-coated with a 15 mg/mL NiOₓ (1 ≤ x ≤ 2) nanoparticle aqueous solution in a glove box at a rate of 2000 rpm/s to have a first hole transport layer formed with a thickness of 30 nm, and then thermally annealed at 150°C for 10 min.
(3) Provision of a first light absorption layer: 1659 mg of lead iodide, 880 mg of lead bromide, 240 mg of formamidinium bromide, 495 mg of formamidinium iodide, 187 mg of cesium iodide, and 102 mg of cesium bromide were weighed and dissolved in 1 mL of a mixed solution of N,N-dimethylformamide (DMF) and dimethyl sulfoxide (DMSO) (a volume ratio of DMF to DMSO was 4:1). After stirred for 1 h, the mixture was filtered with a 0.22 µm organic filter membrane to obtain a perovskite precursor solution. 100 µL of the perovskite precursor solution was taken, and the first hole transport layer was spin-coated with the perovskite precursor solution at 5000 rpm, then placed in a vacuum flash evaporation device for 30s, and transferred to a hot stage at 100°C for annealing for 10 min to have a first light absorption layer (FA_{0.8}Cs_{0.2}Pb(I_{0.6}Br_{0.4})₃) formed with a thickness of 500 nm.
(4) Provision of a first hole blocking layer: Bathocuproine (first hole blocking material, BCP) with a thickness (d₁) of 10 nm was evaporated on the above first light absorption layer as the first hole blocking layer.
(5) Provision of a first electron transport layer: C₆₀ with a thickness of 20 nm was evaporated on the above first hole blocking layer as the first electron transport layer.
(6) Provision of a second hole blocking layer: SnO₂ (second hole blocking material) with a thickness of 20 nm was deposited on the above first electron transport layer by atomic layer deposition as the second hole blocking layer.
(7) Provision of a composite layer: Au with a thickness of 1 nm was evaporated on the second hole blocking layer as the composite layer.
(8) Provision of a second hole transport layer: The above composite layer was spin-coated with a mixed solution of poly(3,4-ethylenedioxythiophene) and poly(styrenesulfonate) at a spin-coating speed of 3000 rpm for 20s, then transferred to a hot stage and annealed at 150°C for 15 min to have a second hole transport layer formed with a thickness of 15 nm.
(9) Provision of a second light absorption layer: 2 mg of formamidinium iodide, 85 mg of methylammonium iodide, 4 mg of lead iodide, and 335 mg of tin iodide were added to 1 mL of a mixed solvent of DMF and DMSO (a volume ratio of DMF to DMSO was 2:1), stirred at 600 rpm on a magnetic stirrer for 2 h, and filtered to obtain a perovskite precursor solution. The above second hole transport layer was spin-coated with 100 µL of the above perovskite precursor solution, first at a spin-coating speed of 1000 rpm and an acceleration of 200 rpm/s for 10s, then at a spin-coating speed of 3000 rpm and an acceleration of 1000 rpm/s for 20s, 500 µL of ethyl acetate was added dropwise to the perovskite precursor solution for spin-coating, and then the perovskite precursor solution was used for spin-coating again at a spin-coating speed of 4000 rpm for 20s, then transferred to a hot stage and annealed at 100°C for 10 min to have a second light absorption layer (FA_{0.7}MA_{0.3}Pb_{0.5}Sn_{0.5}I₃) formed with a thickness of 1 µm.
(10) Provision of a third hole blocking layer: The above second light absorption layer was spin-coated with a 0.5 mg/mL BCP chlorobenzene solution (third hole blocking material), and then transferred to a hot stage and annealed at 100°C for 5 min to have a third hole blocking layer formed with a thickness (d₃) of 7 nm.
(11) Provision of a second electron transport layer: The above third hole blocking layer was spin-coated with a 15 mg/mL fullerene derivative (PCBM) chlorobenzene solution to have a second electron transport layer formed with a thickness of 10 nm.
(12) Provision of a fourth hole blocking layer: Bathocuproine (fourth hole blocking material) with a thickness of 10 nm was evaporated on the above second electron transport layer as the fourth hole blocking layer.
(13) Provision of a second electrode: Metallic copper with a thickness of 100 nm was evaporated on the above fourth hole blocking layer as the second electrode.

### Testing of material HOMO energy level

According to the test data of valence band X-ray photoelectron spectroscopy valence band spectrum (VB XPS), the obtained graph was plotted, and the straight-line part near 0 eV of the obtained graph was extrapolated to intersect with the horizontal extension line. The intersection point was the HOMO energy level of the material.

### Testing of open-circuit voltage (Voc) and photoelectric conversion efficiency (PCE) of tandem solar cells

In an atmospheric environment, an AM1.5G standard light source was used as a solar simulator light source, and a four-channel digital source meter (Keithley 2440) was used to measure the voltammetric characteristic curve of the cell under light irradiation. According to the voltammetric characteristic curve, the open-circuit voltage, short circuit current density (Jsc), and fill factor FF (Fill Factor) of the photoelectricity of the tandem solar cell were obtained.

The photoelectric conversion efficiency (PCE) of the tandem solar cell was calculated using the following formula: $\begin{matrix}PCE = Pout / Popt \\ = Voc \times Jsc \times \left(Vmpp\times Jmpp\right) / \left(Voc\times Jsc\right) \\ = Voc \times Jsc \times FF / Popt\end{matrix}$

Pout, Popt, Vmpp, and Jmpp are the battery operating output power, incident light power, battery maximum power point voltage, and maximum power point current, respectively.

### Example 2

The tandem solar cell was prepared according to the method in Example 1, with the difference that no fourth hole blocking layer was formed.

Performance tests were conducted in the same manner as in Example 1. The test results are shown in Table 2.

### Example 3

The tandem solar cell was prepared according to the method in Example 1, with the difference that no third hole blocking layer or fourth hole blocking layer was formed.

### Example 4

The tandem solar cell was prepared according to the method in Example 1, with the difference that SnO₂ was used as the hole blocking material for the first hole blocking layer.

Performance tests were conducted in the same manner as in Example 1. The test results are shown in Table 2.

### Comparative example 1

The tandem solar cell was prepared according to the method in Example 1, with the difference that no first hole blocking layer, third hole blocking layer, or fourth hole blocking layer was formed.

Performance tests were conducted in the same manner as in Example 1. The test results are shown in Table 2.

### Comparative example 2

The tandem solar cell was prepared according to the method in Example 1, with the difference that no first hole blocking layer or fourth hole blocking layer was formed.

Performance tests were conducted in the same manner as in Example 1. The test results are shown in Table 2.

### Comparative example 3

The tandem solar cell was prepared according to the method in Example 1, with the difference that no first hole blocking layer or third hole blocking layer was formed.

Performance tests were conducted in the same manner as in Example 1. The test results are shown in Table 2.

### Comparative example 4

The tandem solar cell was prepared according to the method in Example 1, with the difference that no first hole blocking layer, third hole blocking layer, or fourth hole blocking layer was formed. A passivation layer was formed between the first light absorption layer and the first electron transport layer. The preparation method of the passivation layer was as follows: 100 µL of phenethylammonium iodide (5 mg/mL) isopropanol solution was taken and used for spin-coating at a spin-coating speed of 4000 rpm and an acceleration of 1000 rpm/s for 25s, and annealed for 5 min to have a passivation layer formed with a thickness of 10 nm.

Performance tests were conducted in the same manner as in Example 1. The test results are shown in Table 2.

**Table 2**

| No. | First hole blocking material | Second hole blocking material | Second light absorption material | Third hole blocking material | Fourth hole blocking material | Voc (V) | PCE (%) |
|---|---|---|---|---|---|---|---|
| Example 1 | BCP | SnO₂ | Perovskite | BCP | BCP | 2.025 | 26.66 |
| Example 2 | BCP | SnO₂ | Perovskite | BCP | - | 2.015 | 26.23 |
| Example 3 | BCP | SnO₂ | Perovskite | - | - | 2.002 | 26.01 |
| Example 4 | SnO₂ | SnO₂ | Perovskite | BCP | BCP | 2.006 | 26.10 |
| Comparative example 1 | - | SnO₂ | Perovskite | - | - | 1.921 | 25.20 |
| Comparative example 2 | - | SnO₂ | Perovskite | BCP | - | 1.940 | 25.42 |
| Comparative example 3 | - | SnO₂ | Perovskite | - | BCP | 1.928 | 25.33 |
| Comparative example 4 | phenethylammonium iodide | SnO₂ | Perovskite | - | - | 1.934 | 25.37 |

It can be seen from the data in Table 2 that the perovskite tandem solar cells prepared in Examples 1 to 4 have a first hole blocking layer arranged between the first light absorption layer and the first electron transport layer. As compared with the perovskite tandem solar cells prepared in Comparative examples 1 to 4, the open-circuit voltage and photoelectric conversion efficiency of the perovskite tandem solar cells prepared in Examples 1 to 4 are both increased.

### Example 5

### Preparation of tandem solar cell (perovskite-crystalline silicon tandem cell):

(1) Provision of a crystalline silicon cell: A textured n-type monocrystalline silicon wafer (c-Si) was sequentially cleaned with a hydrogen peroxide solution, hydrofluoric acid, and hydrochloric acid as a second light absorption layer. Intrinsic amorphous silicon (i-a-Si:H) was deposited on one side by PECVD to passivate the c-Si surface. Then, a p-doped a-Si:H layer (second hole transport layer) with a thickness of about 10 nm was deposited on the i-a-Si:H surface by PECVD. Then, on the other side, a 1.5 nm SiO₂ layer was grown by a wet chemical method (68% by mass concentrated nitric acid was used for oxidation reaction at 90°C for 30 min) as a third hole blocking layer, and then an n-doped a-Si:H layer (second electron transport layer) with a thickness of about 5 nm was deposited on a surface thereof by PECVD. On the n-type layer side, 20 nm ITO was deposited as a composite layer, and on the p-type layer side, 80 nm ITO was deposited by magnetron sputtering (PVD) as a transparent electrode (second electrode). Then, an Ag grid was screen-printed on the p-type side as a back electrode.
(2) Provision of a first hole transport layer: The ITO (composite layer) on the above n-type side was spin-coated with a 15 mg/mL NiOₓ nanoparticle solution in a glove box at a rate of 2000 rpm/s to have a first hole transport layer formed with a thickness of 30 nm, and then thermally annealed at 150°C for 10 min.
(3) Provision of a first light absorption layer: 1659 mg of lead iodide, 880 mg of lead bromide, 240 mg of formamidinium bromide, 495 mg of formamidinium iodide, 187 mg of cesium iodide, and 102 mg of cesium bromide were weighed and dissolved in 1 mL of a mixed solution of N,N-dimethylformamide (DMF) and dimethyl sulfoxide (DMSO) (a volume ratio of DMF to DMSO was 4:1). After stirred for 1 h, the mixture was filtered with a 0.22 µm organic filter membrane to obtain a perovskite precursor solution. 100 µL of the perovskite precursor solution was taken, and the first hole transport layer was spin-coated with the perovskite precursor solution at 5000 rpm, then placed in a vacuum flash evaporation device for 30s, and transferred to a hot stage at 100°C for annealing for 10 min to have a first light absorption layer (FA_{0.8}Cs_{0.2}Pb(I_{0.6}Br_{0.4})₃) formed with a thickness of 500 nm.
(4) Provision of a first hole blocking layer: Bathocuproine (first hole blocking material, BCP) with a thickness (d₁) of 10 nm was evaporated on the above first light absorption layer as the first hole blocking layer.
(5) Provision of a first electron transport layer: C60 with a thickness of 20 nm was evaporated on the above first hole blocking layer as the first electron transport layer.
(6) Provision of a second hole blocking layer: SnO₂ (second hole blocking material) with a thickness of 20 nm was deposited on the above first electron transport layer by atomic layer deposition as the second hole blocking layer.
(7) Provision of a first electrode: Metallic ITO with a thickness of 100 nm was deposited on the above second hole blocking layer by PVD as the first electrode. Performance tests were conducted in the same manner as in Example 1. The test results are shown in Table 3.

### Comparative example 5

The tandem solar cell was prepared according to the method in Example 5, with the difference that no first hole blocking layer was formed.

Performance tests were conducted in the same manner as in Example 5. The test results are shown in Table 3.

**Table 3**

| No. | First hole blocking material | Second light absorption material | Voc (V) | PCE (%) |
|---|---|---|---|---|
| Example 5 | BCP | Crystalline Silicon | 1.815 | 25.77 |
| Comparative example 5 | - | Crystalline Silicon | 1.773 | 23.93 |

It can be seen from the data in Table 3 that the perovskite-crystalline silicon tandem cell prepared in Example 5 has a first hole blocking layer arranged between the first light absorption layer and the first electron transport layer. As compared with the perovskite-crystalline silicon tandem cell prepared in Comparative example 5, the open-circuit voltage and photoelectric conversion efficiency of the perovskite-crystalline silicon tandem cell prepared in Example 5 are both increased.

### Examples 6-9

The tandem solar cells in Examples 6 to 9 were prepared according to the method in Example 1, with the difference that the first hole blocking material or the third hole blocking material was adjusted as shown in Table 4-1.

Performance tests were conducted in the same manner as in Example 1. The test results are shown in Table 4-2.

**Table 4-1**

| No. | First hole blocking material | HOMO energy level of first hole blocking material | HOMO energy level of first light absorption material | σ | Third hole blocking material | HOMO energy level of third hole blocking material | HOMO energy level of second light absorption material | ω |
|---|---|---|---|---|---|---|---|---|
| Example 1 | BCP | -7.0 eV | -5.6 eV | -1.4 eV | BCP | -7.0 eV | -5.1 eV | -1.9 eV |
| Example 6 | TPBI | -6.7 eV | -5.6 eV | -1.1 eV | BCP | -7.0 eV | -5.1 eV | -1.9 eV |
| Example 7 | BN-ICz-1 | -5.62 eV | -5.6 eV | -0.02 eV | BCP | -7.0 eV | -5.1 eV | -1.9 eV |
| Example 8 | BCP | -7.0 eV | -5.6 eV | -1.4 eV | CuPc | -5.2 eV | -5.1 eV | -0.1 eV |
| Example 9 | BCP | -7.0 | -5.6 eV | -1.4 eV | C₅₁H₃₈N₂ | -5.16 eV | -5.1 eV | -0.06 eV |

**Table 4-2**

| No. | Voc (V) | PCE (%) |
|---|---|---|
| Example 1 | 2.025 | 26.66 |
| Example 6 | 2.003 | 26.58 |
| Example 7 | 1.982 | 25.99 |
| Example 8 | 2.009 | 26.60 |
| Example 9 | 1.973 | 25.83 |

It can be seen from Tables 4-1 and 4-2 that when the difference between the HOMO energy level of the first hole blocking material and the HOMO energy level of the perovskite material in the first light absorption layer is less than or equal to -0.1 eV, the open-circuit voltage and photoelectric conversion efficiency of the tandem solar cell can be further increased. Similarly, when the difference between the HOMO energy level of the third hole blocking material and the HOMO energy level of the second light absorption material is less than -0.1 eV, the open-circuit voltage and photoelectric conversion efficiency of the tandem solar cell can be further increased.

### Examples 10 to 13

The tandem solar cells were prepared according to the method in Example 1, with the difference that d₁ or d₃ was adjusted as shown in Table 5.

Performance tests were conducted in the same manner as in Example 1. The test results are shown in Table 5.

**Table 5**

| No. | d₁ (nm) | d₃ (nm) | Voc (V) | PCE (%) |
|---|---|---|---|---|
| Example 1 | 10 | 7 | 2.025 | 26.66 |
| Example 10 | 5 | 7 | 2.003 | 26.32 |
| Example 11 | 16 | 7 | 2.018 | 26.51 |
| Example 12 | 20 | 7 | 1.993 | 26.20 |
| Example 13 | 10 | 5 | 1.982 | 25.85 |

It can be seen from the data in Table 5 that the thickness of the first hole blocking layer being 5 nm to 16 nm is beneficial for further increasing the open-circuit voltage and photoelectric conversion efficiency of the perovskite tandem solar cell. As compared with the data of Example 13, when the thickness of the third hole blocking layer is 7 nm, the open-circuit voltage and photoelectric conversion efficiency of the perovskite tandem solar cell can be further increased.

### Example 14

The tandem solar cell was prepared according to the method in Example 1, with the difference that the step of providing the first hole blocking layer includes: the first light absorption layer was spin-coated with a 0.5 mg/mL bathocuproine chlorobenzene solution, and then transferred to a hot stage and annealed at 100°C for 5 min to have a first hole blocking layer formed with a thickness of 10 nm.

Performance tests were conducted in the same manner as in Example 1. The test results are shown in Table 6.

### Example 15

The tandem solar cell was prepared according to the method in Example 1, with the difference that the step of providing the third hole blocking layer includes: 7 nm of bathocuproine was evaporated as the third hole blocking layer.

Performance tests were conducted in the same manner as in Example 1. The test results are shown in Table 6.

**Table 6**

| No. | First hole blocking material | Preparation method of first hole blocking layer | Third hole blocking material | Preparation method of third hole blocking layer | Voc (V) | PCE (%) |
|---|---|---|---|---|---|---|
| Example 1 | BCP | Vapor | BCP | Solution | 2.025 | 26.66 |
| Example 14 | BCP | Solution | BCP | Solution | 1.982 | 26.05 |
| Example 15 | BCP | Vapor | BCP | Vapor | 2.017 | 26.53 |

It can be seen from the data in Table 6 that as compared with Comparative examples 1 to 4, the open-circuit voltage and photoelectric conversion efficiency of the perovskite tandem solar cells obtained by forming hole blocking layers (first hole blocking layer and third hole blocking layer) using vapor or solution methods are both increased.

This disclosure is not limited to the foregoing embodiments. The foregoing embodiments are merely examples, and embodiments having substantially the same constructions and the same effects as the technical idea within the scope of the technical solutions of this disclosure are all included in the technical scope of this disclosure. In addition, without departing from the essence of this disclosure, various modifications made to the embodiments that can be conceived by persons skilled in the art, and other manners constructed by combining some of the constituent elements in the embodiments are also included in the scope of this disclosure.

## Claims

1. A tandem solar cell, wherein the tandem solar cell comprises a first electrode and a second electrode; at least a first battery cell and a second battery cell arranged in sequence in a first direction between the first electrode and the second electrode; and a composite layer arranged between the first battery cell and the second battery cell, the first direction being a direction of light incidence;
wherein the first battery cell comprises the following stacked layers: a first light absorption layer, a first electron transport layer, a first hole blocking layer arranged on a side of the first electron transport layer closer to the first light absorption layer, and a second hole blocking layer arranged on a side of the first electron transport layer farther away from the first light absorption layer, and the first light absorption layer comprises a perovskite material.

2. The tandem solar cell according to claim 1, wherein the second battery cell comprises the following stacked layers: a second light absorption layer, a second electron transport layer, and a third hole blocking layer arranged between the second light absorption layer and the second electron transport layer.

3. The tandem solar cell according to claim 1 or 2, wherein the first hole blocking layer comprises a first hole blocking material, and a difference between a HOMO energy level of the first hole blocking material and a HOMO energy level of the perovskite material in the first light absorption layer is less than or equal to -0.1 eV.

4. The tandem solar cell according to claim 2, wherein the third hole blocking layer comprises a third hole blocking material, the second light absorption layer comprises a second light absorption material, and a difference between a HOMO energy level of the third hole blocking material and a HOMO energy level of the second light absorption material is less than -0.1 eV.

5. The tandem solar cell according to any one of claims 1 to 4, wherein a thickness of the first hole blocking layer is 5 nm to 20 nm.

6. The tandem solar cell according to claim 5, wherein the thickness of the first hole blocking layer is 5 nm to 16 nm.

7. The tandem solar cell according to claim 2 or 4, wherein a thickness of the third hole blocking layer is 5 nm to 20 nm.

8. The tandem solar cell according to claim 7, wherein the thickness of the third hole blocking layer is 5 nm to 10 nm.

9. The tandem solar cell according to claim 2 or 4, wherein the first battery cell is arranged on the first electrode and comprises a first hole transport layer, the first light absorption layer, the first hole blocking layer, the first electron transport layer, and the second hole blocking layer that are arranged in sequence in the first direction; and
the second battery cell is arranged on the composite layer and comprises a second hole transport layer, the second light absorption layer, the third hole blocking layer, and the second electron transport layer that are arranged in sequence in the first direction, and the second electrode is arranged on a side of the second electron transport layer farther away from the third hole blocking layer;
wherein the second light absorption layer comprises a perovskite material.

10. The tandem solar cell according to claim 2 or 4, wherein the first battery cell is arranged on the first electrode and comprises a first hole transport layer, the first light absorption layer, the first hole blocking layer, the first electron transport layer, and the second hole blocking layer that are arranged in sequence in the first direction; and
the second battery cell is arranged on the composite layer and comprises a second hole transport layer, the second light absorption layer, the third hole blocking layer, and the second electron transport layer that are arranged in sequence in the first direction, wherein the second battery cell further comprises a fourth hole blocking layer arranged on a side of the second electron transport layer farther away from the third hole blocking layer and in contact with the second electron transport layer, and the second electrode is arranged on a side of the fourth hole blocking layer farther away from the second electron transport layer;
wherein the second light absorption layer comprises a perovskite material.

11. The tandem solar cell according to claim 2 or 4, wherein the first battery cell is arranged on the first electrode and comprises the second hole blocking layer, the first electron transport layer, the first hole blocking layer, the first light absorption layer, and the first hole transport layer that are arranged in sequence in the first direction; and
the second battery cell is arranged on the composite layer and comprises the second electron transport layer, the third hole blocking layer, the second light absorption layer, and a second hole transport layer that are arranged in sequence in the first direction, and the second electrode is arranged on a side of the second hole transport layer farther away from the second light absorption layer;
wherein the second light absorption layer comprises a crystalline silicon material.

12. The tandem solar cell according to any one of claims 1 to 10, wherein the first hole blocking layer comprises at least one of 2,9-dimethyl-4,7-diphenyl-1,10-phenanthroline, SnO₂, 1,3,5-tris(1-phenyl-1H-benzimidazol-2-yl)benzene, 1,3-bis[3,5-di(pyridin-3-yl)phenyl]benzene, diphenyl[4-(triphenylsilyl)phenyl]phosphine oxide, 2,7-bis(2,2'-bipyridin-5-yl)triphenylene, bis(8-hydroxy-2-methylquinolinato)-(4-phenylphenoxy)aluminum, [6-(1,10-phenanthrolin-3-yl)naphthalen-2-yl]diphenylphosphine oxide, 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, and bathophenanthroline.

13. The tandem solar cell according to any one of claims 1 to 12, wherein the second hole blocking material may comprise at least one of fullerene and derivatives thereof, 2,9-dimethyl-4,7-diphenyl-1,10-phenanthroline, and SnO₂.

14. The tandem solar cell according to any one of claims 2, 4, and 7-11, wherein the third hole blocking layer comprises at least one of 2,9-dimethyl-4,7-diphenyl-1,10-phenanthroline, SnO₂, 1,3,5-tris(1-phenyl-1H-benzimidazol-2-yl)benzene, 1,3-bis[3,5-di(pyridin-3-yl)phenyl]benzene, diphenyl[4-(triphenylsilyl)phenyl]phosphine oxide, 2,7-bis(2,2'-bipyridin-5-yl)triphenylene, bis(8-hydroxy-2-methylquinolinato)-(4-phenylphenoxy)aluminum, [6-(1,10-phenanthrolin-3-yl)naphthalen-2-yl]diphenylphosphine oxide, 3-(biphenyl-4-yl)-5-(4-tert-butylphenyl)-4-phenyl-4H-1,2,4-triazole, 2-(4-tert-butylphenyl)-5-(4-biphenyl)-1,3,4-oxadiazole, 3,5-diphenyl-4-(1-naphthyl)-1H-1,2,4-triazole, bathophenanthroline, copper phthalocyanine, 8-hydroxyquinolinolato-lithium, BN-ICz-1, and 2,7-bis[N-(m-tolyl)anilino]-9,9'-spirobi[9H-fluorene].

15. The tandem solar cell according to any one of claims 1 to 14, wherein a HOMO energy level of the first light absorption layer of the first battery cell is lower than a HOMO energy level of the second light absorption layer of the second battery cell.

16. A photovoltaic module, wherein the photovoltaic module comprises the tandem solar cell according to any one of claims 1 to 15.

17. A power generation apparatus, wherein the power generation apparatus comprises the tandem solar cell according to any one of claims 1 to 15.

18. An electric apparatus, wherein the electric apparatus comprises the tandem solar cell according to any one of claims 1 to 15.
